# EUROPEAN PATENT APPLICATION

(11) **EP 4 641 621 A1**
(43) Date of publication of application: **29.10.2025**
(21) Application number: 23906414.0
(22) Date of filing: 05.10.2023
(51) Int. Cl.: H01L 21/31, C23C 16/44, H01L 21/324

(54) **TEMPERATURE CONTROL SYSTEM, METHOD FOR MANUFACTURING SEMICONDUCTOR DEVICE, PROCESSING DEVICE, AND PROGRAM**

(30) Priority: 23.12.2022 JP 2022207375
(71) Applicant: Kokusai Electric Corporation, Tokyo 101-0045 (JP)
(72) Inventor: YAMAGUCHI, Hideto, Toyama-shi, Toyama 939-2393 (JP); NAKANISHI, Kento, Toyama-shi, Toyama 939-2393 (JP); SHIGEMATSU, Seiya, Toyama-shi, Toyama 939-2393 (JP)
(74) Representative: Verscht, Thomas Kurt Albert
(86) International application number: PCT/JP2023/036350
(87) International publication number: WO 2024/135039

(57) **Abstract**

Provided is technology that makes it possible to switch between a plurality of temperature sensors and perform temperature control. The present invention comprises a first control mode that controls the temperature in a processing chamber on the basis of the temperature detected by a first temperature sensor positioned at a heating portion, a second control mode that controls the temperature in the processing chamber on the basis of the temperature detected by a second temperature sensor provided to a holding tool for holding a substrate, and a switching unit that is configured to be capable of switching between the first control mode and the second control mode so that temperature control is executed in accordance with a state of the holding tool.

## Description

### [Technical Field]

The present disclosure relates to a temperature control system, a method of manufacturing a semiconductor device, a processing apparatus and a program.

### [Related Art]

As a part of a manufacturing process of a semiconductor device, a predetermined process is performed on a wafer (hereinafter, also referred to as a "substrate") (for example, see Patent Document 1).

For example, a temperature (inner temperature) of a process chamber is controlled using a temperature detected by a temperature sensor which moves with a boat (hereafter, also referred to as a "retainer"). However, when a temperature control is performed using the temperature detected by the temperature sensor while the retainer is being elevated or lowered, an inappropriate state (inappropriate condition) (such as abnormal heating due to an inappropriate position) may occur.

### [Related Art Document]

### [Patent Document]

Patent Document 1: International Patent Publication No. WO 2020-059722

### [Disclosure]

### [Technical Problem]

According to the present disclosure, there is provided a technique capable of controlling a temperature by switching between a plurality of temperature sensors.

### [Technical Solution]

According to an embodiment of the present disclosure, there is provided a technique that includes: a switch configured to be capable of switching between a first control mode and a second control mode so as to perform a temperature control in accordance with a state of a retainer configured to support a substrate thereon, wherein, in the first control mode, an inner temperature of a process chamber is controlled based on a temperature detected by a first temperature sensor provided at a heater, and wherein, in the second control mode, the inner temperature of the process chamber is controlled based on a temperature detected by a second temperature sensor provided at the retainer.

### [Advantageous Effects]

According to some embodiments of the present disclosure, it is possible to control a temperature by switching between a plurality of temperature sensors.

### [Brief Description of Drawings]

FIG. 1 is a diagram schematically illustrating a vertical cross-section of a substrate processing apparatus, when viewed from front, according to embodiments of the present disclosure.
FIG. 2 is a diagram schematically illustrating the substrate processing apparatus according to the embodiments of the present disclosure.
FIG. 3 is a diagram schematically illustrating transition states during a boat loading into the substrate processing apparatus according to the embodiments of the present disclosure, and more specifically, states in which the boat is being elevated.
FIG. 4 is a diagram schematically illustrating a hardware configuration of a controller of the substrate processing apparatus according to the embodiments of the present disclosure.
FIG. 5 is a diagram schematically illustrating a hardware configuration of a temperature controller of the substrate processing apparatus according to the embodiments of the present disclosure.
FIG. 6 is a control block diagram schematically illustrating a temperature control system of the substrate processing apparatus according to the embodiments of the present disclosure.
FIG. 7(A) is a diagram schematically illustrating a substrate processing sequence performed by the substrate processing apparatus according to the embodiments of the present disclosure, and more specifically, a flow chart schematically illustrating the substrate processing sequence, and FIG. 7(B) is a diagram schematically illustrating the substrate processing sequence performed by the substrate processing apparatus according to the embodiments of the present disclosure, and more specifically, a graph schematically illustrating temperatures at each step of the substrate processing sequence.
FIG. 8 is a flow chart schematically illustrating a temperature control sequence performed by the substrate processing apparatus according to the embodiments of the present disclosure.
FIG. 9 is a control block diagram of a modified example of the temperature control system of the substrate processing apparatus according to the embodiments of the present disclosure.
FIG. 10 is a flow chart schematically illustrating a modified example of the temperature control sequence performed by the substrate processing apparatus according to the embodiments of the present disclosure.

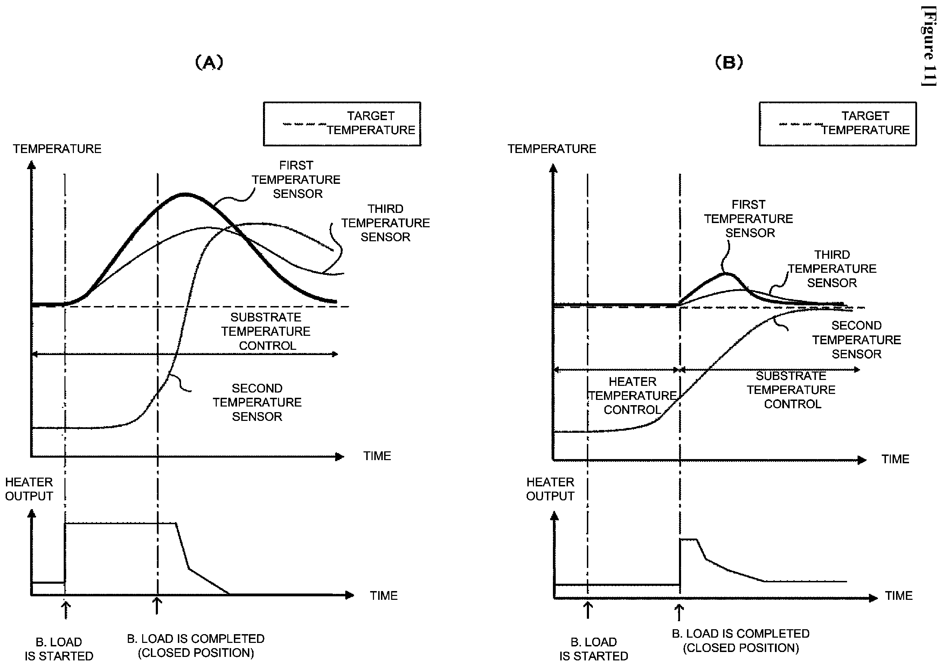

FIG. 11(A) is a diagram for explaining effects of the substrate processing apparatus according to the embodiments of the present disclosure, and more specifically, a graph schematically illustrating a temperature change when a temperature control for a furnace is always set to a substrate temperature control, and FIG. 11(B) is a diagram for explaining the effects of the substrate processing apparatus according to the embodiments of the present disclosure, and more specifically, a graph schematically illustrating a temperature change when the temperature control for the furnace is switched from a heater temperature control to the substrate temperature control.

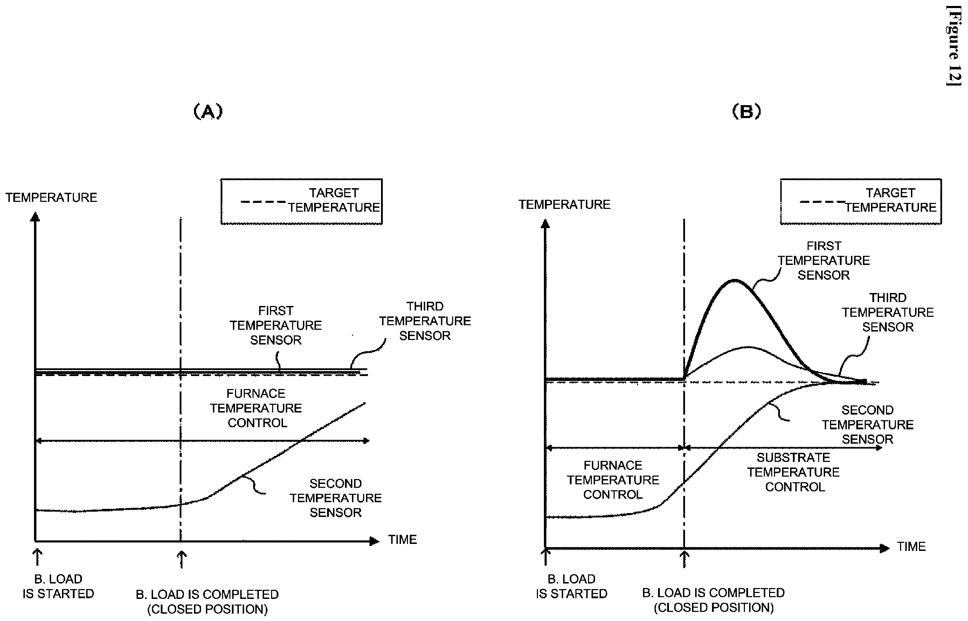

FIG. 12(A) is a diagram for explaining the effects of the substrate processing apparatus according to the embodiments of the present disclosure, and more specifically, a graph schematically illustrating a temperature change when the temperature control for the furnace is always set to the heater temperature control, and FIG. 12(B) is a diagram for explaining the effects of the substrate processing apparatus according to the embodiments of the present disclosure, and more specifically, a graph schematically illustrating a temperature change when the temperature control for the furnace is switched from the heater temperature control to the substrate temperature control.

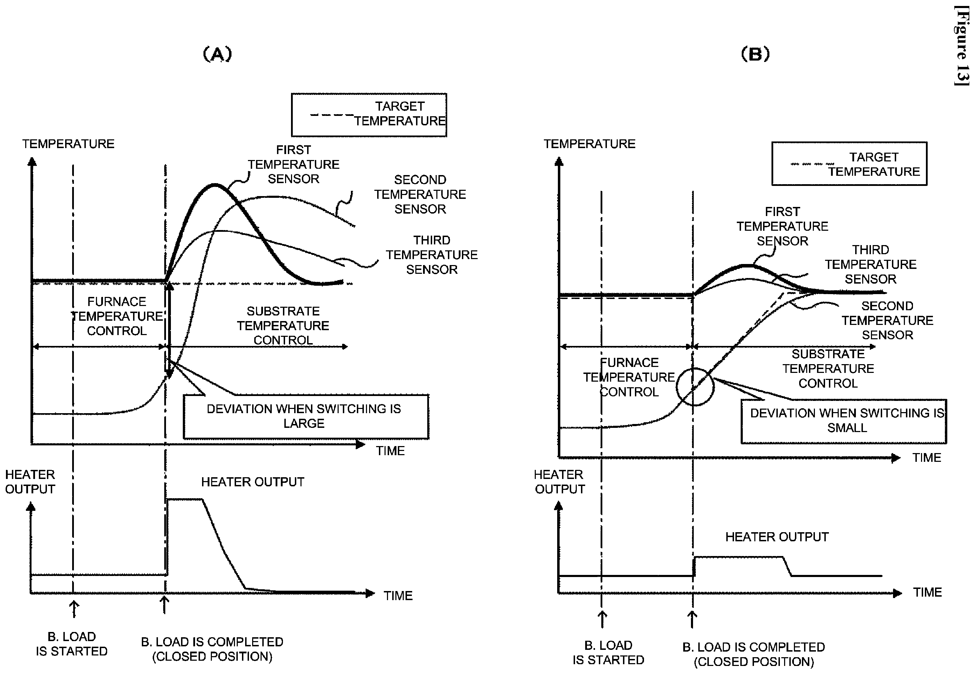

FIG. 13(A) is a diagram for explaining the effects of the substrate processing apparatus according to the embodiments of the present disclosure, and more specifically, a graph schematically illustrating a temperature change when the temperature control for the furnace is switched from the heater temperature control to the substrate temperature control while maintaining a target temperature constant, and FIG. 13(B) is a diagram for explaining the effects of the substrate processing apparatus according to the embodiments of the present disclosure, and more specifically, a graph schematically illustrating a temperature change when the temperature control for the furnace is switched from the heater temperature control to the substrate temperature control while changing the target temperature.

### [Detailed Description]

Hereinafter, embodiments of the technique of the present disclosure will be described in detail with reference to the drawings. The drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match. In addition, the same or similar reference numerals represent the same or similar components in the drawings. Thus, each component is described with reference to the drawing in which it first appears, and redundant descriptions related thereto will be omitted unless particularly necessary.

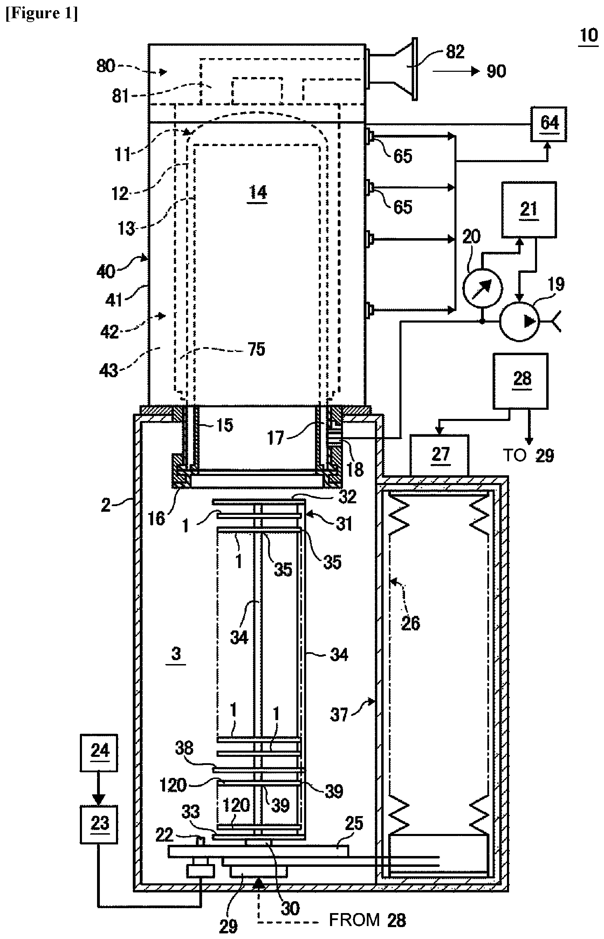

As shown in FIG. 1, a substrate processing apparatus 10 includes a process tube 11 serving as a reaction tube. The process tube 11 is constituted by an outer tube 12 serving as an outer reaction tube and an inner tube 13 serving as an inner reaction tube. The outer tube 12 is provided in a manner concentric with the inner tube 13. For example, the outer tube 12 is made of quartz (SiO₂). The outer tube 12 is of a cylindrical shape with a closed upper end and an open lower end. The inner tube 13 is of a cylindrical shape with open upper and lower ends. A process chamber 14 is defined by a hollow cylindrical portion of the inner tube 13. A boat 31 serving as a retainer can be loaded into the process chamber 14. A lower end opening (opening space) of the inner tube 13 serves as a furnace opening (which is a furnace opening space) 15 for loading the boat 31 into the process chamber 14 and unloading the boat 31 out of the process chamber 14. As will be described later, the boat 31 is configured to accommodate a plurality of substrates (hereinafter, also referred to as "wafers") 1 vertically arranged (or aligned) in a multistage manner.

A lower end portion of the process tube 11 between the outer tube 12 and the inner tube 13 is airtightly sealed by a manifold 16 serving as a furnace opening flange. The manifold 16 is substantially of a cylindrical shape. For example, for exchanging the outer tube 12 and the inner tube 13, the manifold 16 is detachably attached to each of the outer tube 12 and the inner tube 13. By supporting the manifold 16 on a housing 2 of the substrate processing apparatus 10, the process tube 11 is vertically provided on the manifold 16. Hereinafter, in the following drawings, the inner tube 13 which is a part of the process tube 11 may be omitted.

An exhaust path 17 is constituted by a gap between the outer tube 12 and the inner tube 13. The exhaust path 17 is of a circular ring shape with a constant transverse cross-section. As shown in FIG. 1, one end of an exhaust pipe 18 is connected to an upper portion of a side wall of the manifold 16, and the exhaust pipe 18 communicates with a lowermost end portion of the exhaust path 17. An exhauster (which is an exhaust apparatus) 19 controlled by a pressure controller 21 is connected to the other end of the exhaust pipe 18. A pressure sensor 20 is connected to an intermediate location of the exhaust pipe 18. The pressure controller 21 is configured to feedback-control the exhauster 19 based on a measurement result from the pressure sensor 20.

A seal cap 25 serving as a lid capable of airtightly sealing (or closing) a lower end opening of the manifold 16, is provided under the manifold 16. The lid 25 is in contact with the manifold 16 from thereunder. The lid 25 is of a disk shape, and a diameter of the lid 25 is substantially equal to an outer diameter of the manifold 16. The lid 25 is elevated or lowered in a vertical direction by a boat elevator 26 protected by a boat cover 37. The boat cover 37 is provided in a transfer chamber 3 of the housing 2. The boat elevator 26 may be constituted by components such as a motor-driven feed screw shaft device and a bellows. A motor 27 of the boat elevator 26 is controlled by a drive controller 28 described later. A rotating shaft 30 is provided on a center line of the lid 25 so as to be rotatably supported. The rotating shaft 30 is configured to be rotationally driven by a motor 29 controlled by the drive controller 28. The boat 31 is vertically supported at an upper end of the rotating shaft 30. According to the present embodiments, for example, a rotator (which is a rotating structure) is constituted by the rotating shaft 30 and the motor 29.

A gas introduction pipe 22 is provided below the manifold 16 (according to the present embodiments, below the lid 25) so as to communicate with the furnace opening 15 of the inner tube 13. A source gas supplier (which is a source gas supply apparatus), a reactive gas supplier (which is a reactive gas supply apparatus) and an inert gas supplier (which is an inert gas supply apparatus), which constitute a gas supplier (which is a gas supply apparatus) 23, are connected to the gas introduction pipe 22. The gas supplier 23 is configured to be controlled by a gas flow rate controller 24 described later. A gas supplied into the furnace opening 15 through the gas introduction pipe 22 flows through the process chamber 14 of the inner tube 13, and is exhausted through the exhaust path 17 and the exhaust pipe 18.

The boat 31 includes a pair of end plates (that is, an upper end plate 32 and a lower end plate 33) and a plurality of support columns (for example, three support columns) 34 serving as a supporting structure installed vertically between the upper end plate 32 and the lower end plate 33 to connect the upper end plate 32 and the lower end plate 33. A plurality of support recesses 35 are engraved at each of the support columns 34 at equal intervals in a lengthwise direction of each of the support columns 34. The support recesses 35 located at the same stage of each of the support columns 34 are open to face one another. By inserting the substrates 1 into the support recesses 35 located at the same stages of each of the support columns 34, the boat 31 supports the substrates 1 vertically arranged in a multistage manner while the substrates 1 are horizontally oriented with their centers aligned with one another. By inserting a plurality of heat insulating plates 120 into the support recesses 39 located at the same stages of each of the support columns 34, the boat 31 supports the heat insulating plates 120 vertically arranged in a multistage manner while the heat insulating plates 120 are horizontally oriented with their centers aligned with one another.

That is, the boat 31 includes: a substrate processing region between the upper end plate 32 and an end plate 38 where the substrates 1 are accommodated; and a heat insulating plate region between the end plate 38 and the lower end plate 33 where the heat insulating plates 120 are accommodated. The heat insulating plate region is provided below the substrate processing region. For example, a heat insulator (which is a heat insulating assembly) 36 is constituted by the heat insulating plates 120 provided between the end plate 38 and the lower end plate 33.

The rotating shaft 30 is configured to support the boat 31 while the boat 31 is elevated (lifted) from an upper surface of the lid 25. The heat insulator 36 is provided in the furnace opening (furnace opening space) 15 and is configured to thermally insulate the furnace opening 15. In addition, the motor 29 configured to rotate the boat 31 is provided under the lid 25. The motor 29 is configured as a hollow motor structure, and the rotating shaft 30 penetrates (or passes through) the motor 29.

A heater 40 serving as a heating structure is provided at an outside of the process tube 11 in a manner concentric with the process tube 11. The heater 40 is installed while being supported by the housing 2. A heater thermocouple 65 serving as a first temperature sensor is provided at the heater 40. A temperature controller 64 described later is configured to feedback-control the heater 40 based on a measurement result from the first temperature sensor 65. As a result, the heater 40 is configured to heat the substrates 1 in the substrate processing region supported by the boat 31. The first temperature sensor 65 will be described in detail later. In addition, the heater 40 includes a case 41. For example, the case 41 is made of stainless steel (SUS). For example, the case 41 is of a tube shape with a closed upper end and an open lower end. Preferably, the case 41 is of a cylindrical shape. In the present specification, the term "provided at the heater 40" mentioned above may refer to not only "provided in the heater 40" but also "provided in the vicinity of the heater 40".

A heat insulating structure 42 is provided in the case 41. The heat insulating structure 42 includes a sidewall outer layer (hereinafter, also simply referred to as an "outer layer") provided on an outer side of the heat insulating structure 42 and a sidewall inner layer (hereinafter, also simply referred to as an "inner layer") provided on an inner side of the heat insulating structure 42. The heat insulating structure 42 is of a tube shape, preferably, of a cylindrical shape. A sidewall structure 43 of the heat insulating structure 42 of the cylindrical shape is configured as a multilayer structure.

In addition, cooling air 90 flows through a gas supply flow path provided in the inner layer, and then is supplied to a space 75 through a supply path including the gas supply flow path.

As shown in FIG. 1, a ceiling wall structure 80 serving as a ceiling structure is provided on an upper end of the sidewall structure 43 of the heat insulating structure 42. The ceiling wall structure 80 covers the space 75 to close the space 75. An exhaust hole 81 of a ring shape, which is a part of an exhaust path through which an atmosphere (inner atmosphere) of the space 75 is exhausted, is provided in the ceiling wall structure 80. A lower end of the exhaust hole 81, which is an upstream end of the exhaust hole 81, communicates with an inner space (that is, the space) 75. A downstream end of the exhaust hole 81 is connected to an exhaust duct 82. The cooling air 90 ejected into the space 75 is exhausted through the exhaust hole 81 and the exhaust duct 82.

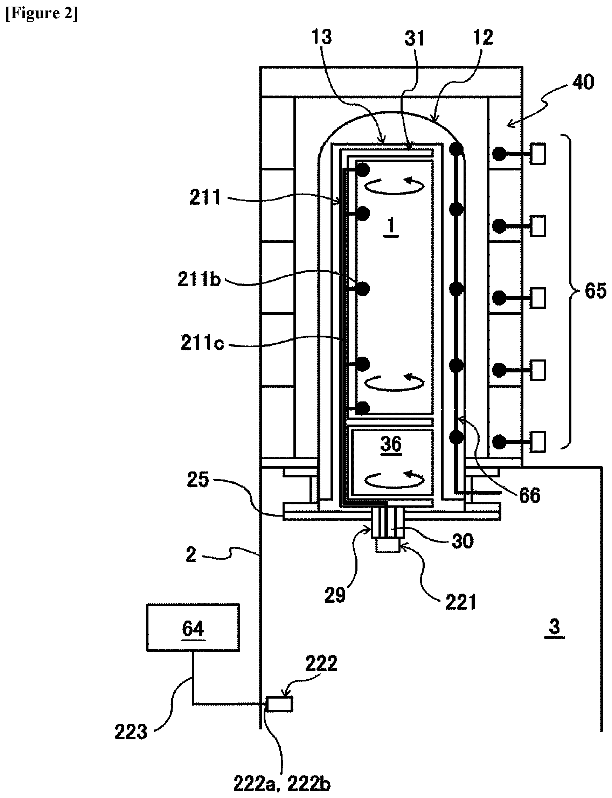

As shown in FIG. 2 (in FIG. 2, the substrate 1 to be processed is indicated as a reference numeral "1", and a detailed illustration thereof is omitted), the case 41 is divided into a plurality of zones in the vertical direction (for example, divided into 5 zones as shown in FIG. 2). In addition, in the heater 40, a sub-heater is provided for each zone, and a temperature of each zone can be individually controlled. That is, the heater 40 is constituted by a plurality of sub-heaters combined with one another. Further, the first temperature sensor 65 configured to measure a temperature of the sub-heater is installed for each zone.

A furnace thermocouple 66 serving as a third temperature sensor is provided at the outer tube 12. The furnace thermocouple 66 is configured to measure a temperature (inner temperature) of the process chamber 14. The furnace thermocouple 66 may be implemented as a structure in which thermocouples whose number is equal to the number of the zones mentioned above are accommodated in a quartz tube. In addition, temperature measurement points of the thermocouples are disposed at positions facing the zones, respectively. In the present specification, the term "provided at the outer tube 12" mentioned above may refer to not only "provided in the outer tube 12" but also "provided in the vicinity of the outer tube 12".

A substrate thermocouple 211 serving as a second temperature sensor configured to measure a temperature of the substrate 1 is provided at the boat 31. The substrate thermocouple 211 is configured to be rotated together with the substrates 1 when the boat 31 and the substrates 1 are rotated. For example, the substrate thermocouple 211 is constituted by: a temperature meter 211b configured to measure a temperature of the substrate 1; and a cable 211c including a wire constituting the temperature meter 211b. In the present specification, the term "provided at the boat 31" mentioned above may refer to not only "provided in the boat 31" but also "provided in the vicinity of the boat 31".

The heater thermocouple 65 serves as an example of the first temperature sensor according to the technique of the present disclosure. The substrate thermocouple 211 serves as an example of the second temperature sensor according to the technique of the present disclosure. The furnace thermocouple 66 serves as an example of the third temperature sensor according to the technique of the present disclosure. However, each of the first temperature sensor, the second temperature sensor and the third temperature sensor is not limited to the thermocouple described above, and may be a sensor capable of measuring a temperature as an electrical signal, such as a resistance type temperature detector.

A hole through which the cable 211c passes through is provided so as to penetrate the rotating shaft 30. The cable 211c can be pulled out to a transmitter 221 and connected to the transmitter 221 provided outside the process chamber 14 (for example, at a lower end of the rotating shaft 30) while vacuum-sealing the hole and its periphery using components such as a hermetic seal. The cable 211c is connected to the transmitter 221 below the lid (seal cap) 25.

The transmitter 221 is fixed to the rotating shaft 30 and is configured to move (rotate) together with the rotating shaft 30. In addition, the transmitter 221 converts an electric signal (voltage) input from the substrate thermocouple 211 via the cable 211c into a digital signal, and transmits the digital signal in a radio wave by using a wireless transmission.

A receiver 222 is provided and fixed to the housing 2 of the transfer chamber 3 below the lid 25. A terminal (output terminal) 222a configured to receive the digital signal transmitted by the transmitter 221 and to output the received digital signal by a serial communication is provided, or a terminal (output terminal) 222b configured to convert the digital signal into an analog signal and to output the analog signal such as a current ranging from 4 mA to 20 mA is provided. A cable 223 is used to connect the output terminal 222a of the digital signal or the output terminal 222b of the analog signal to a temperature indicator (not shown) or the temperature controller 64, and temperature data is input to the temperature controller 64. While the present embodiments are described by way of an example in which the receiver 222 is provided in the transfer chamber 3, the present embodiments are not limited thereto. For example, the receiver 222 may be disposed outside the transfer chamber 3, or may be disposed at a location away from the substrate processing apparatus 10.

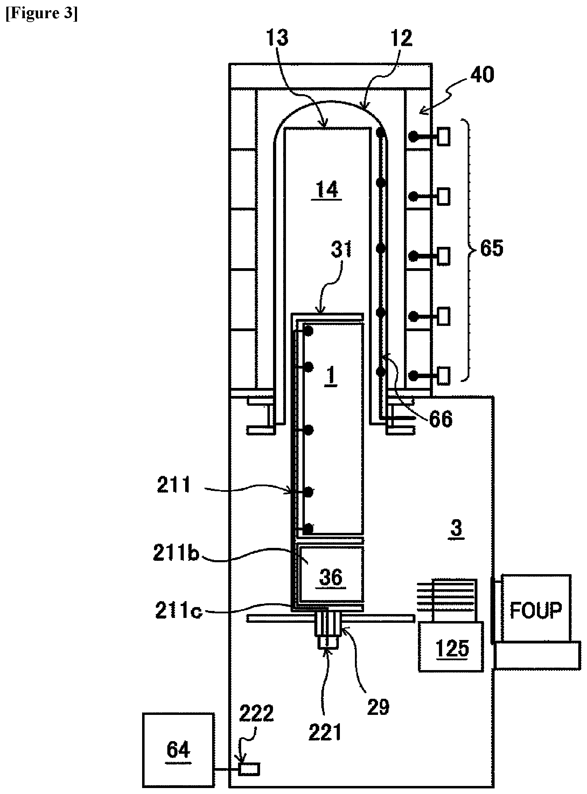

Subsequently, transition states of operations during a boat loading will be described with reference to FIG. 3. FIG. 3 is a diagram schematically illustrating the transition states of the operations (that is, operations of elevating the substrates 1) when the substrates 1 are mounted on the boat 31 and the substrate thermocouple 211 is installed. In FIG. 3, the substrate 1 to be processed is indicated as the reference numeral "1", and the detailed illustration thereof is omitted.

When the substrates 1 are mounted on the boat 31 by a transfer structure (transfer device) 125, the boat 31 is entirely located in the transfer chamber 3.

Then, after the substrates 1 are completely mounted on the boat 31, as shown in FIG. 3, the boat 31 and the transmitter 221 are elevated by the boat elevator 26 (see in FIG. 1).

Thereafter, the lid 25 is fixed by being in contact with the manifold 16, and the boat 31 is stored (accommodated) in the process chamber 14. A position of the boat 31 in such a state may also be referred to as a "closed position".

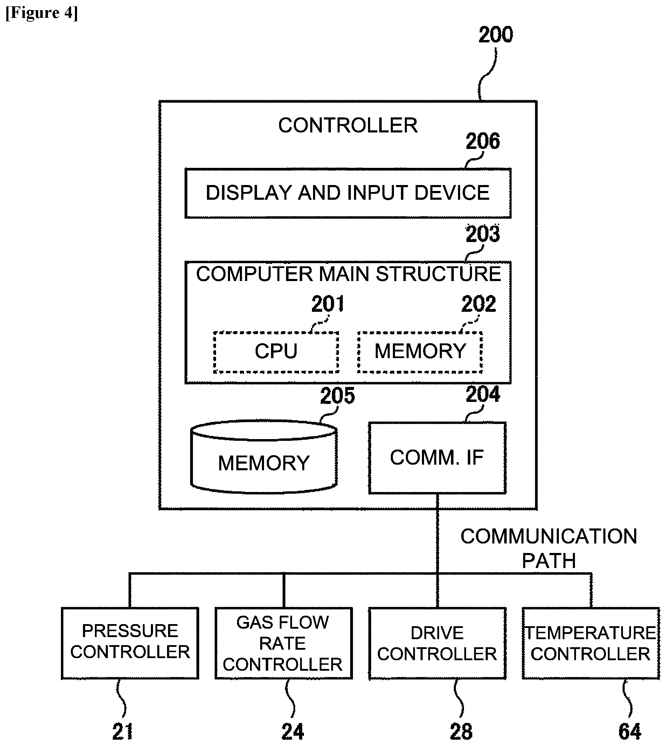

As shown in FIG. 4, a controller 200 (which is a control computer serving as a control structure) includes: a computer main structure 203 including components such as a CPU (Central Processing Unit) 201 and a memory 202; a communication IF (interface) 204 serving as a communication structure; a memory (memory apparatus) 205 serving as a memory structure; and a display and input device 206 serving as a manipulation structure. In other words, the controller 200 includes components of a general-purpose computer.

The CPU 201 constitutes a backbone of a manipulator. The CPU 201 is configured to execute a control program stored in the memory 205 such as a hard disk and a recipe (for example, a process recipe) stored in the memory 205, in accordance with an instruction from the display and input device 206. In addition, as a recording medium for storing data such as an operation program of the CPU 201, a component such as a ROM (Read Only Memory), an EEPROM (Electrically Erasable Programmable Read Only Memory) and a flash memory may be used. In the present embodiments, the memory 202 serving as a temporary memory functions as a work area of the CPU 201. The present embodiments will be described by way of an example in which the controller 200 is used. However, the present embodiments are not limited thereto. For example, the present embodiments may also be applied when a general computer system is used. For example, by installing in the general-purpose computer a program for executing a processing (steps) described later from the recording medium (such as a flexible disk, a CD-ROM and a USB) in which the program is stored, it is possible to perform the processing described later.

The communication interface 204 is electrically connected to the pressure controller 21, the gas flow rate controller 24, the drive controller 28 and the temperature controller 64. The pressure controller 21, the gas flow rate controller 24, the drive controller 28 and the temperature controller 64 may be collectively or individually referred to simply as a "sub-controller". The controller 200 can exchange data on operations of components with the sub-controller through the communication interface 204.

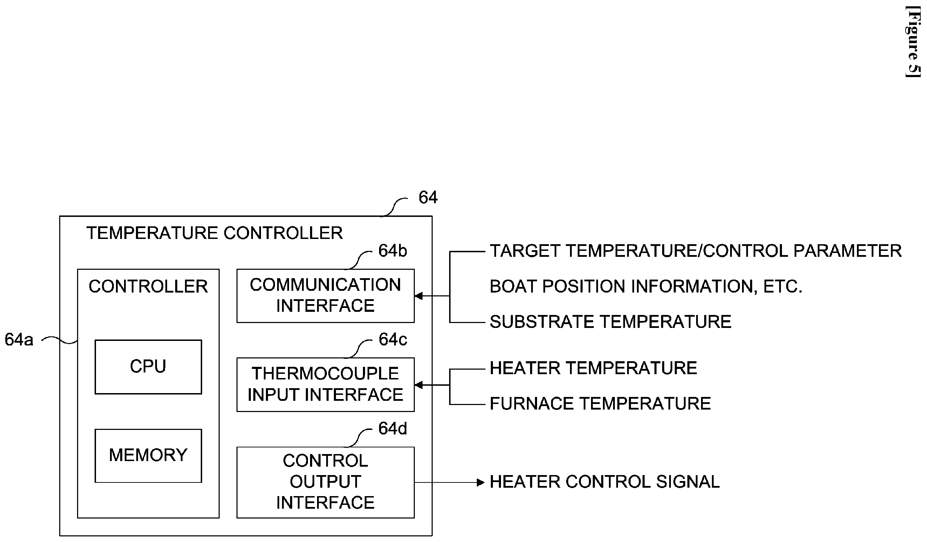

As shown in FIG. 5, the temperature controller 64 includes a controller 64a, a communication interface 64b, a thermocouple input interface 64c and a control output interface 64d.

By executing a control program related thereto, the controller 64a performs a control calculation in accordance with a temperature control algorithm described later by using information acquired through the communication interface 64b and the thermocouple input interface 64c, and outputs a calculation result to the control output interface 64d.

The communication interface 64b includes: a wired IF (interface) for connecting to a component such as the controller 200 (which serves as a higher-level controller or a host controller); and the receiver 222 (which serves as a wireless IF (interface)) for connecting to the transmitter 221 fixed to the boat 31.

The communication interface 64b receives information such as a target temperature and a control parameter from the controller 200, and transmits a control calculation result and temperature information. In addition, the communication interface 64b receives boat position information from the drive controller 28 of the boat elevator 26. In addition, the communication interface 64b receives a temperature of the substrate thermocouple 211 through the transmitter 221 and the receiver 222.

The thermocouple input interface 64c receives an electrical signal corresponding to a temperature from the heater thermocouple 65 or from the furnace thermocouple 66, converts the electrical signal into a digital signal, and outputs the digital signal to the controller 64a.

The control output interface 64d outputs a heater control signal for controlling the temperature of the heater 40 based on the calculation result received from the controller 64a.

In the following explanation, the temperature detected by the heater thermocouple 65 may also be referred to as a "heater temperature", and a temperature control using the heater thermocouple 65 may also be referred to as a "heater temperature control". In addition, the temperature detected by the substrate thermocouple 211 may also be referred to as a "substrate temperature", and a temperature control using the substrate thermocouple 211 may also be referred to as a "substrate temperature control". In addition, the temperature detected by the furnace thermocouple 66 may also be referred to as a "furnace temperature" which is a temperature (inner temperature) of a furnace such as the process chamber 14, and a temperature control using the furnace thermocouple 66 may also be referred to as a "furnace temperature control".

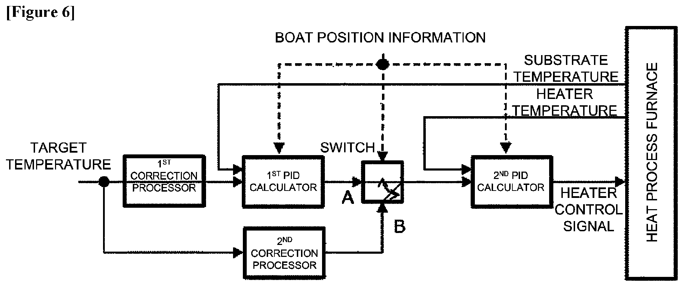

Subsequently, with reference to FIG. 6, an example of a control block diagram of a temperature control system according to the present embodiments will be described. According to the present embodiments, the temperature control system includes a switch (which is a switching structure) configured to be capable of switching between a first control mode (in which the inner temperature of the process chamber 14 is controlled based on the temperature detected by the heater thermocouple 65) and a second control mode (in which the inner temperature of the process chamber 14 is controlled based on the temperature detected by the substrate thermocouple 211) so as to perform the temperature control in accordance with a state of the boat 31.

In the technique of the present disclosure, the "state" of the boat 31 may include the entirety of states (operating states) in which the boat 31 is operating and a state (a stopped state) in which the boat 31 is stopped. For example, the operating states may include: a state (moving state) in which the boat 31 is moving; a state in which the boat 31 is being transported; a state in which the boat 31 is being transferred; a state in which the boat 31 is being elevated or lowered; a state in which the boat 31 is being loaded; a state in which the boat 31 is being unloaded; a state in which the boat 31 is loaded; a state in which the boat 31 is unloaded; a state in which the boat 31 is elevated, a state in which the boat 31 is lowered; and a state in which the boat 31 is being rotated.

A control block shown in FIG. 6 includes: a control mode in which a first correction processor, a first PID (proportional - integral - derivative) calculator, a switch (input terminal "A") and a second PID calculator are connected sequentially in this order; and a control mode in which a second correction processor , the switch (input terminal "B") and the second PID calculator are connected sequentially in this order. The boat position information is input to the first PID calculator, the second PID calculator and the switch.

The temperature controller 64 selects the input terminal of the switch in accordance with the boat position information including the state of the boat 31. In addition, when the boat 31 is in the stopped state, the boat 31 is located in the closed position.

When the boat 31 is in the closed position, the temperature controller 64 selects the input terminal A of the switch and performs a PID control with the substrate temperature and the heater temperature as controlled variables. In the example shown in FIG. 6, as described above, the substrate temperature is the temperature detected by the substrate thermocouple 211, and the heater temperature is the temperature detected by the heater thermocouple 65.

A control when the input terminal of the switch is set to the input terminal A is an example of the second control mode according to the technique of the present disclosure. The second control mode is a control mode in which the control is performed using at least the substrate thermocouple 211 among the heater thermocouple 65 and the substrate thermocouple 211.

When the boat 31 is in a position other than the closed position, the temperature controller 64 selects the input terminal B of the switch and performs a PID control with the heater temperature alone as the controlled variable.

A control when the input terminal of the switch is set to the input terminal B is an example of the first control mode according to the technique of the present disclosure. The first control mode is a control mode in which the control is performed using the heater thermocouple 65 alone among the heater thermocouple 65 and the substrate thermocouple 211.

Each of the first correction processor and the second correction processor is configured to correct the target temperature in accordance with a difference between the target temperature (when controlling the inner temperature of the furnace to be uniform) and another temperature such as the heater temperature and the substrate temperature.

When performing a switching of the switch, an output of the switch may jump and a discontinuous value in the output of the switch may be generated. Thereby, by further inputting the boat position information to the first PID calculator and the second PID calculator and performing a process (such as a so-called bumpless processing and an integral stop processing), it is possible to smoothly control the output of the switch before and after the switching.

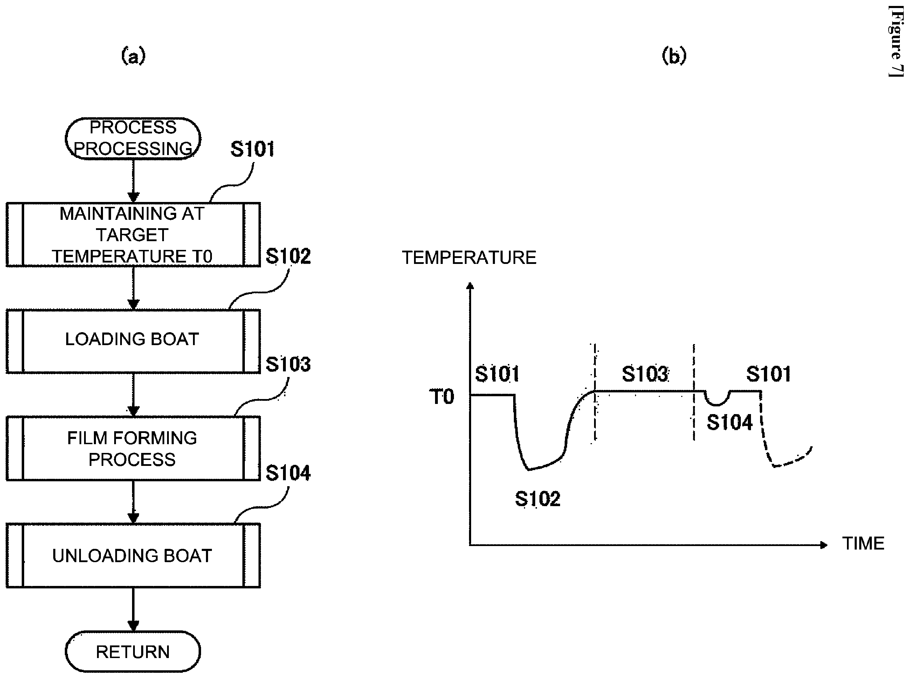

Subsequently, with reference to FIG. 7, an example of a substrate processing sequence performed by the substrate processing apparatus 10 will be described. Specifically, operations of the temperature control system (shown in FIG. 6) mentioned above in each of steps S101, S102, S103 and S104 of the substrate processing sequence shown in FIG. 7(B) will be described.

The step S101 (standby step) is a process of stabilizing the inner temperature of the furnace (such as the inner temperature of the process chamber 14) at a standby temperature T0. In the step S101, the substrate 1 has not yet been inserted into the furnace. In other words, the boat 31 is located (provided) outside the process chamber 14. Since the boat 31 is not located in the closed position, the temperature controller 64 is configured to select the input terminal B of the switch and to perform the temperature control in the first control mode.

The step S102 (boat loading step) is a process of inserting (loading) the substrates 1 accommodated in the boat 31 into the furnace. Because the temperatures of the boat 31 and the substrate 1 are lower than the standby temperature T0 when the substrate 1 is inserted into the furnace and because an atmosphere (outer atmosphere) outside the furnace (which is at a room temperature) is introduced into the furnace as a result of loading the substrates 1 into the furnace, the furnace temperature temporarily falls below the standby temperature T0. Thereafter, by the control of the temperature controller 64, the inner temperature of the furnace is stabilized again at the target temperature (in an example of the present step, the same as the standby temperature T0) after a short period of time. In FIG. 7(B), the target temperature after the substrates 1 to be processed are loaded into the furnace and the target temperature in the subsequent step S103 are shown to be approximately the same as that in the step S101. However, the target temperature after the substrates 1 to be processed are loaded into the furnace may be changed depending on conditions of the step S103.

In the step S102 (boat loading step), the temperature controller 64 is configured to continuously perform the temperature control in the first control mode mentioned above. Then, when the substrates 1 accommodated in the boat 31 are completely loaded into the furnace (that is, when the temperature controller 64 acquires the boat position information indicating that the boat 31 is in the closed position), the temperature controller 64 selects the input terminal A of the switch, switches from the first control mode to the second control mode, and performs the temperature control.

Thereafter, the temperature controller 64 continuously performs the temperature control in the second control mode to stabilize the inner temperature of the furnace at the target temperature T0. When performing such a temperature control, a period from a start of the step S102 (boat loading step) to a completion of loading the substrates 1 into the furnace may also be referred to as a "first period", and a period during which the inner temperature of the furnace is stabilized after the substrates 1 are loaded into the furnace may also be referred to as a "second period". During the second period, the boat 31 is in the stopped state. However, the substrates 1 may be rotated together with the boat 31 by a rotator (not shown). In other words, even when the boat 31 is rotated, the boat 31 is simply being rotated on an own axis thereof, and the boat 31 remains in the closed position. In addition, the second period may be incorporated into the subsequent step S103.

The step S103 (processing step) is a process of performing a predetermined process (such as a film forming process) on the substrates 1 while maintaining the inner temperature of the furnace at the target temperature T0. In the present step, the temperature controller 64 continuously performs the temperature control in the second control mode. In such a state, even when the boat 31 is in operation (that is, being rotated), the boat position information continues to indicate that the boat 31 is in the closed position (that is, unchanged). Therefore, the temperature controller 64 performs the temperature control in the second control mode without switching.

A step S104 (boat unloading step) is a process of transferring (unloading) the substrates 1 (which are processed by the predetermined process) out of the furnace together with the boat 31. In the step S104 (boat unloading step), the temperature controller 64 is configured to select the input terminal B of the switch and to perform the temperature control in the first control mode.

Specifically, at a start of the step S104 (boat unloading step), the temperature controller 64 acquires the boat position information indicating that the boat 31 is not in the closed position, and switches the input terminal A of the switch to the input terminal B to switch from the second control mode to the first control mode. Then, in the S104 (boat unloading step), the temperature controller 64 performs the temperature control in the first control mode.

For example, when there are unprocessed substrates 1 remaining on which the predetermined process is to be performed, the substrates 1 (which are processed) on the boat 31 are removed from the boat 31 and replaced with the unprocessed substrates 1, and a series of processes of the steps S101 through S104 are performed (repeatedly performed).

Each of the steps S101 through S104 is performed after a stable state (that is, the furnace temperature is within a predetermined minute temperature range and such a state continues at least for a predetermined time) is reached.

According to the present embodiments, during an execution of a process recipe including a loading step, a step of processing the substrates 1 and an unloading, the switch is configured to be capable of switching between the first control mode and the second control mode based on the state of the boat 31 such that the temperature control in the first control mode is performed for the inner temperature of the process chamber 14 in the loading step or the unloading step and such that the temperature control in the second control mode is performed for the inner temperature of the process chamber 14 in the step of processing the substrates 1.

In other words, according to the present embodiments, the switch is configured to be capable of switching the control mode such that the inner temperature of the process chamber 14 is controlled in the first control mode while the boat 31 is being moved from an outside of the process chamber 14 toward the process chamber 14, or while the boat 31 is being moved from the process chamber 14 toward the outside of the process chamber 14. On the other hand, the switch is configured to be capable of switching the control mode such that the inner temperature of the process chamber 14 is controlled in the second control mode when the boat 31 is placed (accommodated) in the process chamber 14 (that is, in the stopped state). That is, the switch is configured to be capable of switching the control mode such that the inner temperature of the process chamber 14 is controlled in the second control mode when the boat 31 accommodating (supporting) the substrates 1 is placed in the process chamber 14 and the substrates 1 are processed at a predetermined process temperature. For example, in the present specification, the term "process temperature" may refer to the inner temperature of the process chamber 14.

In addition, in the loading step, the switch is configured to be capable of switching the control mode from the first control mode to the second control mode when the state of the boat 31 is changed from the moving state (toward the process chamber 14) to the stopped state. On the other hand, in the unloading step, the switch is configured to be capable of switching the control mode from the second control mode to the first control mode when the state of the boat 31 is changed from the state in which the boat 31 is placed in the process chamber 14 (that is, the stopped state) to the moving state (away from the process chamber 14), that is, at a timing when a moving operation of the boat 31 to the outside of the process chamber 14 is started.

According to the present embodiments, when the state of the boat 31 is the moving state (for example, the boat 31 is being moved toward the process chamber 14), the control mode can be switched to the first control mode where the substrate thermocouple 211 is not used, and when the state of the boat 31 is a state in which a movement of the boat 31 is completed (that is, when the state of the boat 31 is the stopped state), the control mode can be switched to the second control mode where the substrate thermocouple 211 is used. Therefore, the substrate thermocouple 211 is not used for the temperature control when a position thereof is not appropriate, and the temperature control can be performed in accordance with the state of the boat 31.

In addition, the loading step includes: a first period in which the boat 31 is moved from the outside of the process chamber 14 toward the process chamber 14 (that is, the moving state); and a second period in which the boat 31 is placed in the process chamber 14 (that is, the stopped state). Further, the temperature controller 64 is configured to perform the temperature control in the first control mode during the first period and to perform the temperature control in the second control mode during the second period.

For example, the first period may refer to a period during which the boat 31 is being loaded, and the second period may refer to a period during which the boat 31 is in the stopped state. In addition, the first period may refer to a period during which the retainer is being elevated, and the second period may refer to a period during which the retainer is in a stopped state.

As a result, the substrate thermocouple 211 is not used during the first period when the boat 31 is being moved toward the process chamber 14, and the substrate thermocouple 211 is used during the second period when the movement of the boat 31 is completed (that is, the state of the boat 31 is the stopped state). Therefore, the substrate thermocouple 211 is not used for the temperature control when the position thereof is not appropriate, and the temperature control can be performed in accordance with the state of the boat 31.

For example, the standby temperature detected by the first temperature sensor at a start of the loading step may be configured to be equal to or lower than the process temperature which is set for the step of processing the substrates 1. In such a case, the standby temperature may be equal to a temperature to be maintained when the substrates 1 are not placed in the process chamber 14.

As a result, in the temperature control for a process performed in a low temperature region in which the temperature is equal to or lower than the standby temperature to be maintained when the substrates 1 are not placed, the substrate thermocouple 211 can be used when the movement of the boat 31 is completed in the step (loading step) in which the boat 31 is moved from the outside of the process chamber 14 toward the process chamber 14. Therefore, the substrate thermocouple 211 is not used for the temperature control when the position thereof is not appropriate, and the temperature control can be performed in accordance with the state of the boat 31.

According to the present embodiments, the controller 200 is configured to output an instruction to the temperature controller 64 to perform the subsequent step when a predetermined time (for example, a step time) set in advance has elapsed. According to the present embodiments, the predetermined time (step time) is set individually for each of the steps S101 to S104. In addition, the instruction will be described in detail later as a control switching signal.

As a result, for example, when the predetermined time (for example, the step time) set in advance has elapsed since the moving operation of the boat 31 is started, the switch is configured to be capable of switching from the first control mode to the second control mode.

In addition, for example, the predetermined time set in advance may be equal to a sum of the first period during which the boat 31 is moved toward the process chamber 14 and the second period during which the inner temperature of the process chamber 14 is stabilized.

As a result, the substrate thermocouple 211 is not used in the step in which the boat 31 is moved toward the process chamber 14, and the substrate thermocouple 211 can be used in the step in which the movement of the boat 31 is completed (that is, the state of the boat 31 is the stopped state). Therefore, the substrate thermocouple 211 is not used for the temperature control when the position thereof is not appropriate, and the temperature control can be performed in accordance with the state of the boat 31.

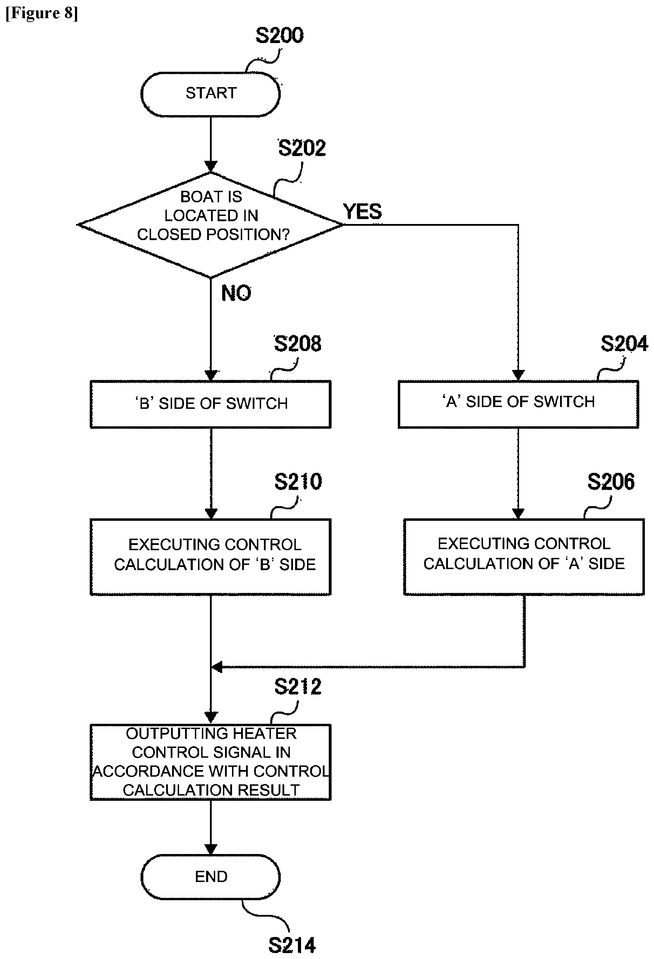

Subsequently, with reference to FIG. 8, an example of a temperature control sequence performed during an execution of the substrate processing sequence will be described.

The temperature control sequence is executed at a timing of a temperature control period. The temperature control sequence is started from a step S200 and is ended (completed) in a step S214.

In a step S202, the temperature controller 64 determines whether the boat 31 is located in the closed position.

When it is determined in the step S202 that the boat 31 is in the closed position, the temperature controller 64 selects the input terminal A of the switch in a step S204, and executes a control calculation in the second control mode in a step S206. Then, in a step S212, the temperature controller 64 outputs the heater control signal in accordance with a control calculation result, and terminates the temperature control sequence.

When it is determined in the step S202 that the boat 31 is not in the closed position, the temperature controller 64 selects the input terminal B of the switch in a step S208, and executes a control calculation in the first control mode in a step S210. Then, in the step S212, the temperature controller 64 outputs the heater control signal in accordance with a control calculation result, and terminates the temperature control sequence.

According to the present embodiments, the substrate processing apparatus 10 is configured to be capable of switching between the first control mode and the second control mode such that, for example, the temperature control for the furnace in the first control mode is performed for the inner temperature of the furnace (the inner temperature of the process chamber 14) when the boat 31 is being moved toward the process chamber 14, and for example, the temperature control for the furnace in the second control mode is performed for the inner temperature of the furnace when the state of the boat 31 is changed from the moving state (toward the process chamber 14) to the stopped state.

According to the present embodiments, for example, when the process chamber 14 is closed by a structure (for example, the lid 25) which moves in association with the boat 31, the switch is configured to be capable of switching from the first control mode to the second control mode. In addition, for example, when the process chamber 14 is sealed by the structure (for example, the lid 25) which moves in association with the boat 31, the switch is configured to be capable of switching from the first control mode to the second control mode.

In addition, the switch is configured to be capable of switching from the first control mode to the second control mode at a timing when the moving operation of the boat 31 toward the process chamber 14 is completed, and capable of switching from the second control mode to the first control mode at the timing when the moving operation of the boat 31 away from the process chamber 14 is started.

As described above, the temperature control is performed based on the control mode in which the substrate thermocouple 211 is not used when the boat 31 is being moved, and the temperature control is performed based on the control mode in which the substrate thermocouple 211 is used when the movement of the boat 31 is completed and the state of the boat 31 is the stopped state. Therefore, the substrate thermocouple 211 is not used for the temperature control when the position thereof is not appropriate, and the temperature control can be performed in accordance with the state of the boat 31.

The present embodiments will be further described with reference to FIG. 11. In a comparative example, as shown in FIG. 11(A), since the temperature of the boat 31 at a start of the boat loading is lower than the inner temperature of the furnace, when the temperature control for the furnace is always set to the substrate temperature control, the inner temperature of the process chamber 14 may become excessively high above the target temperature.

In contrast, as shown in FIG. 11(B), according to the present embodiments, when the boat loading is completed and the boat 31 reaches the closed position, the temperature control for the furnace is switched from the heater temperature control to the substrate temperature control. As a result, as compared with the temperature of the heater thermocouple (first temperature sensor) 65 at the start of the boat loading, it is possible to reduce a difference between the inner temperature of the process chamber 14 and the temperature of the substrate thermocouple (second temperature sensor) 211. Therefore, it is possible to suppress a degree (extent) to which the inner temperature of the process chamber 14 becomes higher than the target temperature.

In addition, by performing the temperature control using the substrate thermocouple 211 when the boat 31 is stopped in the furnace, it is possible to shorten a time for the temperature detected by the substrate thermocouple 211 (the substrate temperature) to reach the target temperature.

### <Modified Example>

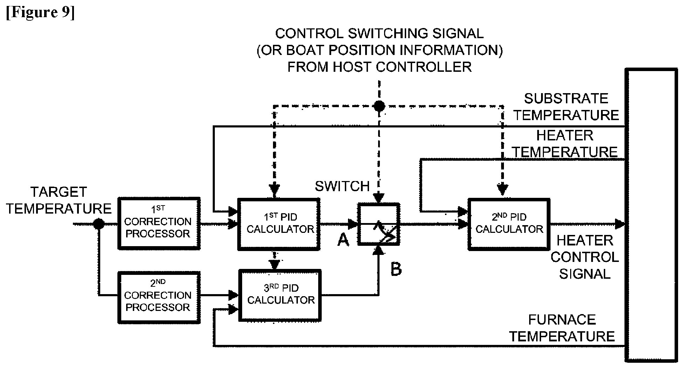

Subsequently, with reference to FIG. 9, a modified example of the control block diagram of the temperature control system according to the present embodiments will be described. According to the present modified example, the temperature control system includes a switch (which is a switching structure) configured to be capable of switching between a third control mode (in which the inner temperature of the process chamber 14 is controlled based on the temperature detected by the furnace thermocouple 66) and the second control mode (in which the inner temperature of the process chamber 14 is controlled based on the temperature detected by the substrate thermocouple 211) so as to perform the temperature control in accordance with the state of the boat 31. A difference from the embodiments mentioned above is merely that the first control mode is replaced with the third control mode, and even in such a configuration, it is possible to obtain substantially the same effects as the embodiments mentioned above.

A control block shown in FIG. 9 includes: a control mode (which is substantially the same as the second control mode according to the embodiments mentioned above) in which a first correction processor, a first PID calculator, a switch (input terminal "A") and a second PID calculator are connected sequentially in this order; and a control mode in which a second correction processor, a third PID calculator, the switch (input terminal "B") and the second PID calculator are connected sequentially in this order.

The boat position information or the control switching signal from the controller 200 is input to the first PID calculator, the second PID calculator and the switch. In the present modified example, the control switching signal is a control signal for instructing a switching between a mode in which the substrate thermocouple 211 is used and a mode in which the substrate thermocouple 211 is not used, and includes a control signal instructing a switching of the steps mentioned above.

The temperature controller 64 selects an input terminal of the switch in accordance with the boat position information including the state of the boat 31. In addition, when the boat 31 is in the stopped state, the boat 31 is located in the closed position.

When the boat 31 is in the closed position, the temperature controller 64 selects the input terminal A of the switch and performs the PID control with the substrate temperature and the heater temperature as controlled variables.

When the boat 31 is in a position other than the closed position, the temperature controller 64 selects the input terminal B of the switch and performs a PID control with the furnace temperature and the heater temperature as controlled variables. In the present modified example, the term "furnace temperature" may refer to the temperature detected by the furnace thermocouple 66.

A control when the input terminal of the switch is set to the input terminal B is an example of the third control mode according to the present modified example. The third control mode is a control mode in which the control is performed using at least one among the furnace thermocouple 66 and the heater thermocouple 65.

Each of the first correction processor and the second correction processor is configured to correct the target temperature in accordance with a difference between the target temperature (when controlling the inner temperature of the furnace to be uniform) and the temperature (such as the heater temperature and the substrate temperature).

When performing the switching of the switch, the output of the switch may jump and a discontinuous value in the output of the switch may be generated. Thereby, by further inputting the boat position information to the first PID calculator, the second PID calculator and performing the process (such as a so-called bumpless processing and the integral stop processing), it is possible to smoothly control the output of the switch before and after the switching.

In addition, the second PID calculator and the third PID calculator may be configured to perform the same calculation in order to simplify the control calculation.

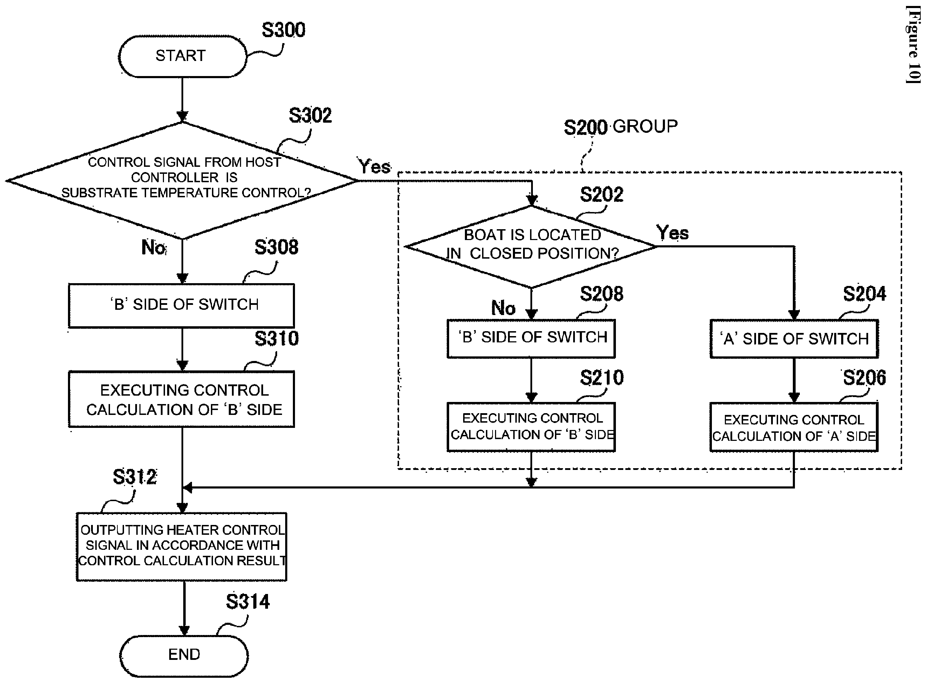

Subsequently, with reference to FIG. 10, a modified example of the temperature control sequence performed during the execution of the substrate processing sequence will be described.

The temperature control sequence is executed at the timing of the temperature control period. The temperature control sequence is started from a step S300 and is ended (completed) in a step S314.

In a step S302, the temperature controller 64 determines whether the control switching signal received from the controller 200 such as the host controller is the control signal instructing to select the mode in which the substrate thermocouple 211 is used.

When it is determined in the step S302 that the control switching signal is the control signal instructing to select the mode in which the substrate thermocouple 211 is used, a step S200 group is preformed. That is, in the step S200 group, when the boat 31 is in the closed position, the temperature controller 64 performs the steps S202, S204 and S206 mentioned above using the boat position information including the state of the boat 31 acquired together with the control switching signal. Then, in a step S312, the temperature controller 64 outputs the heater control signal in accordance with a control calculation result, and terminates the temperature control sequence.

When it is determined in the step S302 that the control switching signal is the control signal instructing to select the mode in which the substrate thermocouple 211 is not used, the temperature controller 64 selects the input terminal B of the switch in a step S308, and executes a control calculation in the third control mode in a step S310. Then, in the step S312, the temperature controller 64 outputs the heater control signal in accordance with a control calculation result, and terminates the temperature control sequence.

According to the present modified example, in the step S302, the temperature controller 64 (which received an instruction to transition to a subsequent step as the control switching signal from the controller 200) checks step information. For example, in the substrate processing sequence shown in FIG. 7(A), when the instruction received as described above is an instruction to transition from the step S101 to the step S102, from the step S103 to the step S104, or from the step S104 to the step S101, it is determined that what is received is the control signal instructing to select the mode in which the substrate thermocouple 211 is not used; and when the instruction received as described above is an instruction to transition from the step S102 to the step S103, it is determined that what is received is the control signal instructing to select the mode in which the substrate thermocouple 211 is used.

According to the present modified example, instead of the first control mode, the control block includes the third control mode in which the inner temperature of the process chamber 14 is controlled based on the temperature detected by the third temperature sensor disposed in the vicinity of a vessel in which the process chamber 14 is provided. When the boat 31 is being moved, for example, during the boat loading or the boat unloading, the temperature control in the third control mode is performed for the inner temperature of the process chamber 14. Specifically, the switch is configured to be capable of switching to the third control mode such that the inner temperature of the process chamber 14 is controlled in the third control mode while the boat 31 is being moved from the outside of the process chamber 14 toward the process chamber 14, or while the boat 31 is being moved from the process chamber 14 toward the outside of the process chamber 14.

In addition, during a period during which the boat 31 is being moved toward the process chamber 14 (a predetermined time duration after the start of the moving operation), the third temperature sensor can be used instead of the first temperature sensor, and when the movement of the boat 31 is completed, the second temperature sensor can be used as in the embodiments mentioned above.

Thus, in the present modified example, similarly to the embodiments mentioned above, for example, in the step in which the boat 31 is moved toward the process chamber 14, the substrate thermocouple 211 is configured to be used when the movement of the boat 31 is completed. Therefore, the substrate thermocouple 211 is not used for the temperature control when the position thereof is not appropriate, and the temperature control can be performed in accordance with the state of the boat 31.

In addition, when the movement of the boat 31 is started from the state in which the boat 31 is placed in the process chamber 14, the switch may be configured to be capable of switching from the third control mode to the second control mode. Even in such a configuration, it is possible to obtain substantially the same effects as the embodiments mentioned above.

Subsequently, the present modified example will be further described with reference to FIG. 12. As shown in FIG. 12(A), when the temperature control for the furnace is always set to the furnace temperature control, after the boat loading is completed and the boat 31 reaches the closed position, the temperature detected by the third temperature sensor 66 reaches the target temperature. However, it takes time for the temperature of the substrate 1 (that is, the substrate temperature) to reach the inner temperature of the furnace (that is, the target temperature). In addition, although not shown in FIG. 12(A), in a similar manner, when the temperature control for the furnace is always set to the heater temperature control, the temperature detected by the first temperature sensor 65 reaches the target temperature. However, it takes time for the temperature of the substrate 1 (that is, the substrate temperature) to reach the inner temperature of the furnace (that is, the target temperature) after the boat 31 reaches the closed position.

In contrast, as shown in FIG. 12(B), when the boat loading is completed and the boat 31 reaches the closed position, the temperature control for the furnace is switched from the furnace temperature control to the substrate temperature control. As a result, as compared with a case where the substrate temperature control is not performed (as shown in FIG. 12(A)), it is possible to adjust the temperature of the substrate 1 to the target temperature in a short period of time.

For example, the embodiments and the modified example mentioned above may be appropriately combined. Process procedures and process conditions of each combination thereof may be substantially the same as those of the embodiments or the modified example mentioned above. Further, the number of each component described in the present specification is not limited to one, and the number of each component described in the present specification may be two or more unless otherwise specified in the present specification.

### <Other Embodiments of Present Disclosure>

While the technique of the present disclosure is described in detail by way of the embodiments and the modified example mentioned above, the technique of the present disclosure is not limited thereto and may be modified in various ways without departing from the scope thereof. For example, the embodiments described above are mainly described by way of an example in which the temperature detected by the substrate thermocouple (second temperature sensor) 211 is regarded as the substrate temperature. However, the technique of the present disclosure is not limited thereto. For example, the term "substrate temperature" may mean a broader term, such as a temperature detected by a temperature sensor which is closest to the substrate among a plurality of temperature sensors and which is installed in the same processing space as the substrate.

For example, a controller capable of selectively executing either the third control mode or the second control mode may be provided. In addition, the controller may be capable of switching from the third control mode to the second control mode when the state of the boat 31 is changed to the stopped state, and capable of setting an intermediate target temperature in accordance with a predetermined proportion in relation to the target temperature.

With such a configuration, even when there is a temperature discrepancy between the substrate thermocouple 211 and other temperature sensors that occurs when switching the control modes, it is possible to suppress an abnormal heating by the heater 40 due to the temperature discrepancy between the temperature detected by the temperature sensor and the substrate temperature, and it is also possible to suppress an overshoot caused by an overheating by the heater 40 due to an erroneous detection by the temperature sensor. In addition, it is possible to expect a reduction in an unnecessary power consumption by the heater 40.

Specifically, as shown in FIG. 13(A), immediately after the temperature control for the furnace is switched from the furnace temperature control to the substrate temperature control, since a deviation between the target temperature and the substrate temperature is large, the furnace temperature temporarily becomes higher than the target temperature.

Therefore, as shown in FIG. 13(B), according to the present embodiments, for a certain period of time after the temperature control for the furnace is switched from the furnace temperature control to the substrate temperature control, the intermediate target temperature is set by lowering the target temperature in accordance with the predetermined proportion in relation to the target temperature.

In an example shown in FIG. 13(B), immediately after the temperature control for the furnace is switched from the furnace temperature control to the substrate temperature control, the intermediate target temperature is set to the same temperature as the temperature detected by the substrate thermocouple 211, and the intermediate target temperature is changed so as to gradually approach the target temperature from the temperature set as described above.

As a result, it is possible to reduce the deviation between the target temperature and the substrate temperature after the temperature control for the furnace is switched from the furnace temperature control to the substrate temperature control. Thereby, it is possible to suppress the overshoot of the furnace temperature.

For example, the embodiments mentioned above are described by way of an example in which a batch and vertical type apparatus capable of simultaneously processing a plurality of substrates is used as the substrate processing apparatus to form the film. However, the technique of the present disclosure is not limited thereto. For example, the technique of the present disclosure may be preferably applied when a single wafer type substrate processing apparatus capable of processing one or several substrates at a time is used as the substrate processing apparatus to form the film.

For example, the technique of the present disclosure may be applied not only to a semiconductor manufacturing apparatus configured to manufacture a semiconductor but also to an apparatus configured to process a glass substrate such as an LCD (Liquid Crystal Display) device. In addition, for example, the substrate processing may include a process such as a CVD (chemical vapor deposition) process, a PVD (physical vapor deposition) process, a process of forming an oxide film or a nitride film, a process of forming a film containing a metal, an annealing process, an oxidation process, a nitridation process and a diffusion process. In addition, the technique of the present disclosure may also be applied to other substrate processing apparatuses such as an exposure apparatus, a coating apparatus, a drying apparatus and a heating apparatus.

The entire contents of Japanese Patent Application No. 2022-207375, filed on December 23, 2022, are hereby incorporated in the present specification by reference. All documents, patent applications, and technical standards described in the present specification are hereby incorporated in the present specification by reference to the same extent that the contents of each of the documents, the patent applications and the technical standards are specifically described.

### [Industrial Applicability]

The technique of the present disclosure can also be applied to a substrate processing apparatus including a substrate retainer (such as the retainer mentioned above) provided with a temperature sensor and configured to process a plurality of substrates accommodated in the substrate retainer.

### [Description of Reference Numerals]

1 Substrate (wafer), 14 Process chamber, 31 Boat (substrate retainer), 40 Heater (heating structure), 64 Temperature controller, 65 Heater thermocouple (first temperature sensor), 211 Substrate thermocouple (second temperature sensor)

## Claims

1. A temperature control system comprising:
a switch configured to be capable of switching between a first control mode and a second control mode so as to perform a temperature control in accordance with a state of a retainer configured to support a substrate thereon,
wherein, in the first control mode, an inner temperature of a process chamber is controlled based on a temperature detected by a first temperature sensor provided at a heater, and
wherein, in the second control mode, the inner temperature of the process chamber is controlled based on a temperature detected by a second temperature sensor provided at the retainer.

2. The temperature control system of claim 1, wherein the switch is further configured to be capable of switching to the first control mode such that the temperature control for the process chamber is performed based on the first control mode while the retainer is being moved from an outside of the process chamber toward the process chamber, or while the retainer is being moved from the process chamber toward the outside of the process chamber.

3. The temperature control system of claim 1, wherein the switch is further configured to be capable of switching from the first control mode to the second control mode such that the temperature control for the process chamber is performed based on the second control mode when the state of the retainer is changed from a moving state toward the process chamber to a stopped state.

4. The temperature control system of claim 1, wherein the switch is further configured to be capable of switching from the first control mode to the second control mode when the process chamber is closed by a structure which moves in association with the retainer, such that the temperature control for the process chamber is performed based on the second control mode.

5. The temperature control system of claim 1, wherein the switch is further configured to be capable of switching from the first control mode to the second control mode at a timing when a moving operation of the retainer toward the process chamber is completed, and capable of switching from the second control mode to the first control mode at a timing when a moving operation of the retainer away from the process chamber is started.

6. The temperature control system of claim 1, wherein the switch is further configured to be capable of switching from the first control mode to the second control mode when a predetermined time set in advance has elapsed after a moving operation of the retainer toward the process chamber is started.

7. The temperature control system of claim 6, wherein the predetermined time set in advance is a step time of a process recipe.

8. The temperature control system of claim 6, wherein the predetermined time set in advance is equal to a sum of a first period during which the retainer is moved toward the process chamber and a second period during which the inner temperature of the process chamber is stabilized.

9. The temperature control system of claim 1, wherein the switch is further configured to be capable of switching from the second control mode to the first control mode at a timing when a moving operation of the retainer from the process chamber toward an outside of the process chamber is started.

10. The temperature control system of claim 7, wherein the process recipe comprises: a loading step; a step of processing the substrate; and an unloading step, and
wherein the switch is further configured to be capable of switching from the second control mode to the first control mode based on the state of the retainer such that the temperature control for the process chamber is performed based on the first control mode in the loading step or the unloading step.

11. The temperature control system of claim 10, wherein the loading step comprises a first period during which the retainer is moved toward the process chamber and a second period in which the retainer is placed in the process chamber, and
the second period is a period during which the inner temperature of the process chamber is stabilized.

12. The temperature control system of claim 11, wherein the first period is a period during which the retainer is being loaded, and the second period is a period during which the retainer is in a stopped state.

13. The temperature control system of claim 7, wherein the process recipe comprises: a loading step; a step of processing the substrate; and an unloading step, and
wherein the switch is further configured to be capable of switching from the first control mode to the second control mode based on the state of the retainer such that the temperature control for the process chamber is performed based on the second control mode in the step of processing the substrate.

14. The temperature control system of claim 10, wherein a standby temperature detected by the first temperature sensor at a start of the loading step is equal to or lower than a process temperature set for the step of processing the substrate.

15. The temperature control system of claim 14, wherein the standby temperature is equal to a temperature to be maintained when the substrate is not placed in the process chamber.

16. The temperature control system of claim 1, wherein the switch is further configured to be capable of switching to a third control mode such that the temperature control for the process chamber is performed based on the third control mode while the retainer is being moved from an outside of the process chamber toward the process chamber, or while the retainer is being moved from the process chamber toward the outside of the process chamber, and
wherein, in the third control mode, the inner temperature of the process chamber is controlled based on a temperature detected by a third temperature sensor provided at the process chamber.

17. The temperature control system of claim 1, further comprising
a controller configured to be capable of selectively executing either the first control mode or the second control mode, and
wherein the controller is further configured to be capable of switching from the first control mode to the second control mode when the state of the retainer is changed to a stopped state, and capable of setting an intermediate target temperature in accordance with a predetermined proportion in relation to a target temperature.

18. A method of manufacturing a semiconductor device, comprising
setting the inner temperature of the process chamber to a process temperature by using the temperature control system of any one of claims 1 to 17; and
processing the substrate placed in the process chamber while maintaining the process temperature.

19. A processing apparatus comprising
a temperature control system comprising
a switch configured to be capable of switching between a first control mode and a second control mode so as to perform a temperature control in accordance with a state of a retainer configured to support a substrate thereon,
wherein, in the first control mode, an inner temperature of a process chamber is controlled based on a temperature detected by a first temperature sensor provided at a heater, and
wherein, in the second control mode, the inner temperature of the process chamber is controlled based on a temperature detected by a second temperature sensor provided at the retainer.

20. A program related to a processing apparatus comprising a temperature control system comprising: a switch configured to be capable of switching between a first control mode and a second control mode so as to perform a temperature control in accordance with a state of a retainer configured support a substrate thereon, wherein, in the first control mode, an inner temperature of a process chamber is controlled based on a temperature detected by a first temperature sensor provided at a heater, and wherein, in the second control mode, the inner temperature of the process chamber is controlled based on a temperature detected by a second temperature sensor provided at the retainer, wherein the program causes the processing apparatus, by a computer, to perform the temperature control.
